# EUROPÄISCHE PATENTANMELDUNG

(11) **EP 0 904 853 A2**
(43) Veröffentlichungstag der Anmeldung: **31.03.1999**
(21) Anmeldenummer: 98118081.3
(22) Anmeldetag: 24.09.1998
(51) Int. Cl.: B05D 3/06, B05D 5/10

(54) **Verfahren zur Vernetzung von strahlungsvernetzbaren Haftklebstoffschichten**

(30) Priorität: 29.09.1997 DE 19743014
(71) Anmelder: BASF AKTIENGESELLSCHAFT, 67056 Ludwigshafen (DE)
(72) Erfinder: Meyer-Roscher, Bernd, Dr., 67363 Lustadt (DE); Schrof, Wolfgang, Dr., 67271 Neuleiningen (DE); Urban, Dieter, Dr., 67346 Speyer (DE); Geiss, Paul Ludwig, 55743 Idar-Oberstein (DE); Brockmann, Walter, Prof., 67661 Kaiserslautern (DE)
(74) Vertreter: Isenbruck, Günter, Dr.

(57) **Zusammenfassung**

Es wird ein Verfahren zur Vernetzung von strahlungsvernetzbaren Haftklebstoffschichten durch dosierte Bestrahlung mit aktinischer Strahlung beschrieben, bei dem die Schichtoberfläche einem regelmäßigen oder regellosen Strahlungsmuster aus Bereichen unterschiedlicher Intensität ausgesetzt wird. Das Verfahren erlaubt eine genauere Einstellung der Haftung, insbesondere von flexiblen Folien auf einem Substrat.

## Beschreibung

Die Erfindung betrifft ein Verfahren zur dosierten Vernetzung von Haftklebstoffschichten durch Strahlung, insbesondere UV-Licht.

Bei konventionellen druckempfindlichen Klebstoffen PSA (= pressure sensitive adhesives) auf Acrylat-, SBC- oder NR-Basis [SBC = Styrol-Blockcopolymere wie SIS ( = Styrol/Isopren/Styrol) oder SBS ( = Styrol/Butadien/Styrol), SBR ( = styrene/butadiene rubber); NR = nitrile rubber = Butadien/Acrylnitril-Kautschuk] in Hotmelt-, Dispersions- oder Lösemittelauftragsweise können die PSA-Eigenschaften durch die Zugabe von klebrigmachenden Substanzen (Tackifier) beeinflußt werden. Dazu gehören sowohl klebrigmachende Harze als auch Weichmacher, z.B. Öle.

Haftklebstoffe der neueren Generation basieren auf lösemittelfreien Schmelzhaftklebern, die nach dem Aufbringen als Schicht auf eine Unterlage bzw. ein Substrat durch Bestrahlen, insbesondere mit UV-Licht, vernetzt werden können. Derartige Klebstoffe sind z.B. von Auchter, Barwich, Rehmer und Jäger in dem Artikel "UV-vernetzbare Acrylat-Schmelzhaftklebstoffe" in "kleben & dichten" 37 (1993), Seite 14 bis 20 und in den EP-A 377 199 und 448 741 beschrieben. Das Grundpolymere wird so hergestellt, daß es sich in der Nähe des sogenannten Gelpunktes befindet. Mit Hilfe von Photoinitiatoren, die entweder zugemischt oder chemisch gebunden werden, sensibilisiert man das Polymere gegenüber energiereicher Strahlung, insbesondere der UV-A-Strahlung. Durch die gezielte Belichtung mit einer bestimmten UV-Dosis läßt sich der Vernetzungsgrad des Polymeren einstellen. Dieser Vernetzungsgrad bestimmt maßgeblich die Endeigenschaften des Haftklebstoffs. So kann z.B. mit ein und demselben Polymeren, nur durch Bestrahlung mit unterschiedlichen UV-Dosen, ein sehr klebriges Haftetikett hergestellt werden, das sogar noch auf feuchten Untergründen haftet, oder ein Klebeetikett, das so weit vernetzt ist, daß es sich rückstandsfrei von beliebigen Oberflächen wieder abziehen läßt.

Solche Endeigenschaften lassen sich grundsätzlich wie vorstehend beschrieben einstellen. Es wird nur mit so viel UV-Licht bestrahlt, bis die gewünschten Eigenschaften eingestellt sind. Eine "Überbelichtung" würde sonst die Produkteigenschaften drastisch ändern.

Optimale Haftklebstoffeigenschaften, die durch den "Tack" (Klebrigkeit), den Schälwiderstand und die Scherfestigkeit (holding power and shear adhesion failure temperature = SAFT) beschrieben werden, sind aber nur schwer in einer homogenen Haftklebemasse zu vereinbaren. Hoher Tack und hoher Schälwiderstand sind verbunden mit mangelhafter Scherfestigkeit und umgekehrt.

Aufgabe der Erfindung war es, die Eigenschaften einer strahlungsvernetzbaren Haftklebstoffschicht derart gezielt zu beeinflussen, daß eine insgesamt optimale Kombination der vorstehend beschriebenen Eigenschaften erreicht wird.

Erfindungsgemäß wird ein Verfahren zur Vernetzung von strahlungsvernetzbaren Haftklebstoffschichten durch dosierte Bestrahlung mit aktinischer Strahlung vorgeschlagen, das darin besteht, daß man die Schichtoberfläche einem regelmäßigen oder regellosen Strahlungsmuster aus Bereichen unterschiedlicher Intensität aussetzt.

Gemäß einer Ausführungsform des Verfahrens besteht das Strahlungsmuster aus Bereichen endlicher Intensität neben strahlungslosen Bereichen.

Als aktinische Strahlung soll im Ramen vorliegender Erfindung jede Strahlung verstanden werden, die in der zu bestrahlenden vernetzbaren Schicht eine irreversible Vernetzung hervorruft. Geeignet sind besonders UV-Licht, kurzwelliges sichtbares Licht und Elektronenstrahlung.

Das erfindungsgemäße Verfahren bietet eine erweiterte Möglichkeit, die Endeigenschaften strahlungsvernetzbarer, insbesondere UV-vernetzbarer Haftklebstoffe zu steuern: durch örtlich begrenzte Bestrahlung in der Klebfläche ist es möglich, nebeneinanderliegende, mehr oder weniger stark oder gar nicht vernetzte Bereiche in einer Schicht aus einer strahlungsvernetzbaren Haftklebemasse zu erzeugen.

Dies kann durch selektive Bestrahlung der zu vernetzenden Bereiche, z.B. durch mit optischen oder magnetischen Linsen fokussierte UV- oder Elektronenstrahlung, erfolgen oder durch rasterartige Bestrahlung, z.B. mit geeignetem, zeitlich und örtlich gesteuertem Laserlicht.

Dies kann aber auch durch gezielte Abschattung der weniger zu vernetzenden Bereiche der Haftkleberschicht durch Masken, Schablonen oder mit durch Interferenzphänomene erzeugten Dunkel- bzw. Schattenbereichen erfolgen. Die dafür notwendigen Einrichtungen können bei einem kontinuierlichen Verarbeitungsprozeß entweder mit den zu bestrahlenden bahnförmigen Trägern mitlaufen oder fest montiert sein und ein örtlich bewegliches Schatten- bzw. Intensitätsmuster erzeugen.

Durch die genannten Möglichkeiten zur örtlich inhomogenen Bestrahlung wird eine örtlich inhomogene Vernetzung bewirkt, die ein Vernetzungsmuster in der Schicht aus Haftklebemasse erzeugt. Dieses Vernetzungsmuster kann regellos statistisch verteilte mehr und weniger stark vernetzte Bereiche aufweisen oder ein sich wiederholendes regelmäßiges Muster sein. Dabei können die stärker vernetzten Bereiche zusammenhängen und inselförmige Bereiche weniger stark vernetzter Haftklebemasse umschließen, es können aber auch die weniger stark vernetzten Bereiche zusammenhängen und die stärker vernetzten Bereiche umschließen.

Die Größe der inselförmigen Bereiche kann von nur Wenigen Nanometern bis zu einigen Zentimetern reichen, vorzugsweise jedoch in der Größenordnung von 0,001 bis zu 10 mm liegen.

Die flächenmäßigen Anteile der mehr oder weniger vernetzten Bereiche an der Gesamtfläche der Haftklebemasse können jeweils zwischen 2 und 98% variieren. Vorzugsweise liegen sie zwischen 10 und 90%.

Durch die Anwendung des erfindungsgemäßen Verfahrens, wird es möglich, neben der Zusammensetzung der Klebstoffschicht und der Bestrahlungsintensität einen weiteren Parameter, nämlich die flächenmäßige Struktur (Muster) und den flächenmäßigen Anteil (Verteilung) mehr und weniger stark vernetzter Bereiche, zur gezielten Beeinflussung der Haftungseigenschaften zur Verfügung zu stellen.

Insbesondere können weniger stark vernetzte Bereiche zu einer Verbesserung der Klebrigkeit (Tack) des bestrahlten Materials beitragen. Obwohl diese weniger stark vernetzten Bereiche nur eine geringe Scherfestigkeit aufweisen, können sie durch ein sie umschließendes Muster von stärker vernetzten Bereichen abgestützt und gegen Abscheren bzw. Fließen unter Lasten gesichert werden.

Dies ermöglicht die Herstellung von neuartigen Produkten mit selbstklebenden, durch UV- oder Elektronenstrahlung vernetzbaren Haftklebemassen, die hinsichtlich der Kombination von Klebrigkeit (Tack) und Scherfestigkeit den heute verfügbaren Produkten überlegen sind.

Andererseits können durch geeignete Wahl der Bestrahlungsparameter die Anteile und die Eigenschaften der mehr und der weniger vernetzten Bereiche so gewählt werden, daß man einen leicht und nahezu rückstandsfrei ablösbaren Klebestreifen erhält. Dies wird insbesondere dann erreicht, wem die gesamte Klebstofffläche einer vernetzenden Bestrahlung ausgesetzt wird und dabei einzelne Bereiche so stark vernetzt werden, daß sie hinsichtlich der Klebrigkeit nahezu deaktiviert sind.

Bei der Herstellung von Packbändern kam die Anwendung der örtlich selektiven Vernetzung des Klebstoffauftrags zu einer Verringerung der Geräuschentwicklung beim Abrollen des Packbandes von der Rolle führen. Dadurch kann die als störend empfundene Lärmbelästigung an Verpackungsarbeitsplätzen auf ein erträgliches Maß reduziert werden.

Eine weitere Anwendung ergibt sich aus der Möglichkeit, daß sich unvernetzte Bereiche des Klebstoffauftrags beim Entfernen kohäsiv (d.h. unter Fadenziehen und Trennung in der Klebstoffmasse selbst unter Zurücklassen von Klebstoffresten sowohl auf dem Träger des Klebstreifens als auch auf der beklebten Oberfläche) und stärker vernetzte Bereiche des Klebstoffauftrags beim Entfernen adhäsiv (d.h. nahezu rückstandsfrei bezüglich der belebten Oberfläche) trennen. Bilden die unvernetzten Bereiche des Klebstoffs ein Muster oder einen Schriftzug, so hinterläßt der Versuch, den so hergestellten Klebestreifen zu entfernen, deutliche Spuren in der Oberfläche des Klebstreifens und der beklebten Oberfläche, die den Entfernungsversuch belegen, weswegen ein derartig hergestellter Klebestreifen als siegelartiger Verschluß verwendet werden kann, bzw. im Bereich der Sicherheitsetikettierung Einsatz finden kann.

Der Vernetzungsgrad der bei dem erfindungsgemäßen Verfahren eingesetzten Haftklebstoffschichten wird im allgemeinen durch Absorptionsmessung an der bestrahlten Schicht ermittelt. Diese enthält vorzugsweise polymerisierbare oder vernetzbare Verbindungen zusammen mit Vernetzungs- oder Polymerisationsinitiatoren, die durch aktinische Strahlung aktiviert und durch Teilnahme an der Reaktion verändert werden. Dabei ändert sich gewöhnlich ihre Absorption, so daß die Absorptionsmessung zur Ermittlung des Umsetzungsgrades dienen kann.

Die Absorptionsmessung erfolgt bevorzugt nach dem in der älteren, nicht vorveröffentlichten deutschen Patentanmeldung 197 07 967.9 beschriebenen Verfahren durch konfokale Ramanspektroskopie oder konfokale Fluoreszenzspektroskopie.

Die Photoinitiatoren liegen in der Haftklebstoffschicht vorzugsweise chemisch, z.B. durch Covalenzen, an die vernetzbaren Verbindungen gebunden vor. Als Photoinitiatoren sind in an sich bekannter Weise alle Verbindungen geeignet, die durch Bestrahlung mit UV-Licht in einen angeregten Zustand übergehen können, in dem sie mit den vernetzbaren Verbindungen zu reagieren vermögen. Als besonders geeignet für diesen Zweck haben sich aromatische Carbonylverbindungen, insbesondere Benzophenon, seine Derivate und Substitutionsprodukte - die hier zusammengefaßt als Benzophenonverbindungen bezeichnet werden - erwiesen. Bei der Vernetzung reagieren nach gegenwärtigem Kenntnisstand durch Strahlung aktivierte Carbonylgruppen unter Ausbildung einer Benzhydrol-Vernetzungsstruktur, wie es in der eingangs genannten Veröffentlichung "UV-vernetzbare Acrylat-Schmelzhaftklebstoffe" beschrieben ist.

Bei der Umsetzung reagieren die Benzophenonreste ab, das heißt charakteristische Banden im Spektrum verschwinden.

Als vernetzbare Verbindungen kommen insbesondere Polymere und Oligomere von (Meth)acrylestern in Betracht. Geeignete Verbindungen sind unter anderem in der EP-A 448 741 beschrieben. Dies sind Copolymere von (Meth)acrylsäurederivaten, die durch Phenonreste, insbesondere Benzophenonreste, substituiert sind, mit unsubstituierten (Meth)acrylsäureestern.

Die vernetzbaren Massen können generell als Schmelzen, als Lösungen oder Dispersionen verarbeitet werden. Sie eignen sich insbesondere zur Herstellung von Haftklebern, Haftklebefolien und Haftklebeetiketten sowie auch von Prägezangenfolien. Dabei können die Massen in üblicher Weise, gegebenenfalls bei erhöhter Temperatur, etwa bei 20 bis 150°C auf übliche Substrate, wie Papier, Pappe, Holz, Metalle und Kunststoffolien, z.B. aus weichgemachtem PVC, Polyethylen, Polyamiden, Polyestern oder Polypropylen, aufgebracht werden.

Die gegebenenfalls getrockneten oder vorgetrockneten Aufträge werden anschließend durch Bestrahlen mit UV-Licht vernetzt, wobei man gut klebende Überzüge erhält, die eine hohe Kohäsion und eine gute Schälfestigkeit bei vorzüglicher Alterungsbeständigkeit aufweisen. Dabei braucht nicht unter Inertgasatmosphäre bestrahlt zu werden, man kann vielmehr an der Luft arbeiten. Als UV-Strahler können die üblichen Strahler, z.B. Quecksilberdampfnieder-, -mittel- und -hochdrucklampen eingesetzt werden. In manchen Fällen kam bei der vernetzenden Bestrahlung gleichzeitig durch den IR-Anteil der Lampen restliches Lösemittel oder Wasser entfernt werden.

Der Vernetzungsgrad der vernetzten Haftklebstoffschichten wird durch Raman- oder Fluoreszenzspektroskopie bestimmt, wobei anhand der Intensität charakteristischer Spektralbanden der Grad der Umsetzung des Photoinitiators ermittelt wird.

Die Ramanspektroskopie erlaubt über die Analyse von Molekülschwingungen eine chemische Identifizierung ähnlich wie die weitverbreitete Infrarotspektroskopie.

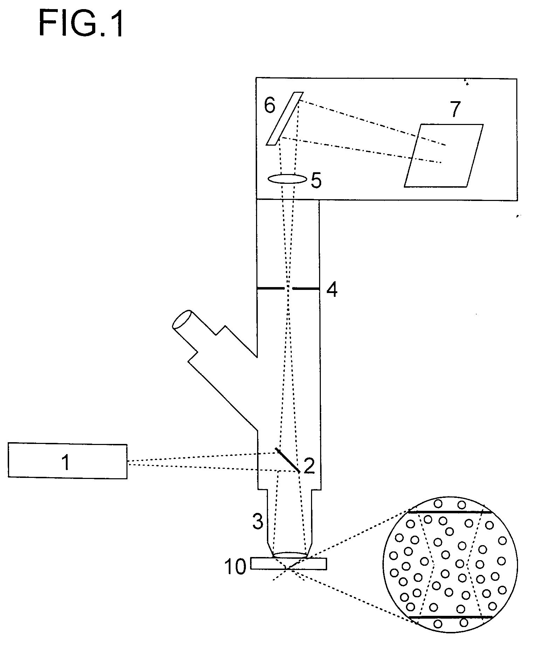

Die konfokale Ramanmikroskopie vereinigt die chemische Strukturinformation der Ramanspektroskopie mit der hohen Ortsauflösung konfokaler optischer Mikroskopie von ca. 1 µm³ (siehe Figur 1). Der Aufbau verknüpft ein konfokales Mikroskop mit einem Ramanspektrometer derart, daß ein Laser über die Abbildungsoptik des Mikroskops auf ein sehr kleines Meßvolumen fokussiert wird. Das entstandene Ramanlicht wird im Nachweisstrahlengang zuerst vom Laserlicht spektral getrennt (z.B. über ein holographisches Notchfilter). Über eine konfokale Blende im Nachweisstrahlengang wird die Tiefenebene selektiert und somit das Meßvolumen dreidimensional auf wenige µm³ eingegrenzt. Ein einfacher lichtstarker Gitterspektrograph kann die spektrale Zerlegung des Ramanlichts übernehmen. Die Detektion erfolgt z.B. mit einem zweidimensionalen CCD-Chip.

Neben der flächenhaften Abbildung chemischer Strukturen gelingen auch Tiefenprofile mit µm-Auflösung. Aufwendige Probenpräparationen entfallen zumeist. Eine Dotierung mit Markierungssubstanzen ist meistens unnötig.

Dieses Meßverfahren ermöglicht es, den für die Endeigenschaften verantwortlichen Vernetzungsgrad eines Haftklebstoffs exakt zu erfassen.

Dabei wird ausgenützt, daß der Photoinitiator sich während der UV-Belichtung chemisch verändert. Diese Reaktion kann über die Abnahme charakteristischer Raman- bzw. Fluoreszenzbanden sehr exakt verfolgt werden und gibt über die Vernetzung Auskunft. Im Besonderen kann auch bestimmt werden, ob der Photoinitiator vollständig verbraucht worden ist, also keine UV-Nachhärtung befürchtet werden muß, welche die Klebwirkung verändern kann.

Neben der Erfüllung der oben aufgeführten Aufgaben kann die konfokale Raman- oder Fluoreszenzspektroskopie zur Qualitätskontrolle von Haftklebstoffprodukten herangezogen werden. Hier kommt zum einen die Qualitätskontrolle bei der Klebstoffproduktion in Betracht und zum anderen die Qualitätskontrolle beim vernetzten Klebstoffilm.

Eine Vorrichtung zur Durchführung des vorstehend beschriebenen Meßverfahrens wird im folgenden anhand der Figur 1 beschrieben. Diese zeigt den schematischen Aufbau einer Vorrichtung zur Anwendung der konfokalen Ramanspektroskopie zur Messung des Vernetzungsgrads.

Die Vorrichtung gemäß Figur 1 beruht im wesentlichen auf einer Kombination eines konfokalen Mikroskops mit einer Laserlichtquelle und einem Raman-Spektrometer. Das Anregungslicht einer Laserlichtquelle 1 wird hier von einem Notchfilter 2 umgeleitet, so daß es über das Objektiv 3 des Mikroskops in die zu untersuchende Probe 10 gelangt. Ein Notchfilter ist für die Umlerkung besonders geeignet, weil es die bestimmte Laserwellenlänge fast vollständig reflektiert. Es können aber auch herkömmliche Spiegelanordnungen verwendet werden. Das Objektiv 3 definiert den Querschnitt des Beobachtungsvolumens in der Probe 10, da es das Anregungslicht des Lasers 1 fokussiert und der entstehende Lichtkegel die Ausbreitung des Laserlichts in der Probe senkrecht zur Einfallsrichtung begrenzt. Das in der Probe 10 inelastisch gestreute Laserlicht wird aus der Probe über das Objektiv 3 aufgenommen und über das Notchfilter 2, das dabei aus der Probe 10 reflektiertes Anregungslicht wegfiltert, zu einer konfokalen Blende 4 weitergeleitet. Diese Blende 4 wählt durch ihre Ausblendwirkung die Tiefenschärfe des Beobachtungsvolumens in der Probe 10 aus, also dessen Lage in der Probe in Einfallsrichtung des Anregungslichts. Nach der Blende 4 gelangt das Raman-Streulicht über eine Linse 5 zu einem Gitterspektrographen 6, der das Streulicht spektral zerlegt. Die einzelnen Spektrallinien werden dann zu einem zweidimensionalen CCD-Chip 7 als Photodetektor geleitet, mit dessen Hilfe die Intensität der Bande gemessen wird. Unterschiedliche Tiefen können durch Verändern des Abstands von Probe und Objektiv eingestellt werden.

Mit einem analogen Aufbau der Meßvorrichtung kann auch der tiefenaufgelöste Vernetzungsgrad von Haftkleberschichten durch konfokale Fluoreszenzspektroskopie ermittelt werden. Dazu ist zweckmäßig in der Vorrichtung gemäß Figur 1 als Lichtquelle eine UV-Lichtquelle und vorteilhaft anstelle des Notchfilters 2 ein Kantenfilter einzusetzen. Die Auswertung des Fluoreszenzemissionsspektrums der Probe kann in an sich bekannter Weise analog zu der vorstehend beschriebenen Ramanspektroskopie erfolgen.

Die Klebeeigenschaften von flächigen Substraten, die eine Haftklebeschicht aufweisen, können durch Messen der Scherfestigkeit als Maß für die Kohäsion und der Schälfestigkeit als zusammenfassendes Maß für Kohäsion und Adhäsion erfaßt werden. Für die Prüfung werden Folien aus Polyethylenterephthalat oder Aluminium mit einer Haftkleberschicht derart beschichtet, daß sich eine Trockenschichtdicke von 25 bis 80 µm ergibt.

Für die Prüfung der lösemittelfreien Schmelzhaftkleber werden auf einem beheizten Streichtisch Polyethylenterephthalatfolien mit den Haftklebermassen bei 85 bis 120°C so beschichtet, daß sich eine Schichtdicke von etwa 25 µm ergibt.

Sofern für die Prüfung gelöste Copolymere eingesetzt werden, werden die Lösemittel 1 Minute bei 70°C und 1 bar abgedampft. Die beschichteten und getrockneten Folien werden mit dem Licht von Quecksilbermitteldrucklampen bestrahlt.

Die Bestrahlung erfolgt mit einer oder mehreren hintereinander angeordneten Quecksilbermitteldrucklampen mit einer Leistung von jeweils 80 bis 160 Watt je cm Strahlenlänge. Die beschichteten und getrockneten Folien werden auf ein laufendes Endlosband gelegt, so daß die beschichteten Folien in einem Abstand von 5 bis 50 cm mit einer Geschwindigkeit von 6 bis 20 m/min unter den Lampen hindurchlaufen. Die Bestrahlung erfolgt an der Luft.

Die so hergestellten Folien werden in 2,5 cm breite Streifen geschnitten und diese Streifen auf ein Aluminiumblech mit einer gummierten Stahlrolle angerollt. Die Platte wird mit den Streifen 24 h bei 23°C und 65 % relativer Luftfeuchtigkeit gelagert.

Zur Messung der Schälfestigkeit werden die Prüfstreifen parallel zur Klebschicht mit einer Geschwindigkeit von 100 mm je Minute rückwärts abgezogen. Die hierfür erforderliche Kraft wird gemessen.

Zur Messung der Soforthaftung (Tack) wird ein 2,5 cm breiter Klebstreifen von 150 mm Länge zu einer Schlinge geformt und die beiden Enden des Klebstreifens in die Klemmbacken einer Zugprüfmaschine gespannt. Die Klebstreifenschlinge wird in Kontakt mit einer Testplatte aus nichtrostendem StahI oder Aluminium gebracht und das Klebeband sofort mit einer Geschwindigkeit von 300 mm je Minute abgezogen. Die für das Abziehen des Streifens von der Stahlplatte erforderliche Kraft wird gemessen. Aus 6 Messungen wird der Mittelwert gebildet.

Bei der Messung der Scherfestigkeit wird ein mit Klebstoff beschichteter und wie beschrieben bestrahlter, 25 mm breiter Substratstreifen auf eine Länge von 25 mm mit einer um 3° gegen die Senkrechte geneigten Prüfplatte aus Glas oder Edelstahl verklebt. Die Neigung der Platte garantiert, daß keine schälenden Kräfte auf die Klebung wirken. Der überhängende Teil des Klebstreifens wird mit einem Gewicht von 1 kg belastet. Danach wird die belastete Probe 5 Stunden bei Raumtemperatur gehalten und anschließend mit einer Heizrate von 2°C je Stunde erwärmt. Es werden die Zeit und Temperatur bestimmt, bis sich die Verklebung löst. Während des gesamten Tests wird die Temperatur der Probe in °C und die Verformung der Probe (Kriechweg) in µm gemessen.

Die in den folgenden Beispielen angegebenen Teile und Prozente beziehen sich auf das Gewicht. Die Bestimmung der K-Werte erfolgt nach DIN53726 in 1%iger Lösung in Tetrahydrofuran bei 25°C. Die Schmelzviskositäten werden mit einem Kegel-Platte-Rheometer z.B. Rotovisko® RV 20 mit Meßeinrichtung PK 100 (Firma Haake, Karlsruhe) gemessen (D = Schergeschwindigkeit in s⁻¹).

Der Staudingerindex (Viskositätszahl) wird in Tetrahydrofuran bei 25 °C nach bekannten Methoden bestimmt (z.B. G.V. Schuh, H.-J. Cantow in Houben - Weyl, Methoden der organischen Chemie, G. Thieme Verlag, 1955, Bd. 3/1, Seiten 431 bis 445 und B. Vollmert: Grundriss der makromolekularen Chemie, Band III, Seite 55 ff).

### BEISPIEL 1

### Copolymerisatlösung P1

Zu einem Gemisch von
- 160 g: Ethylacetat,
- 50 g: Tetrahydrofuran und
- 9 g: tert.-Butylperoxy-2-ethyl-hexanoat
wurden 150 g einer Monomerenmischung aus
- 500 g: Isoamylacrylat,
- 300 g: 2-Ethyl-hexylacrylat,
- 170 g: Methylacrylat,
- 30 g: Acrylsäure und
- 7,5 g: eines Benzophenonderivats der Formel 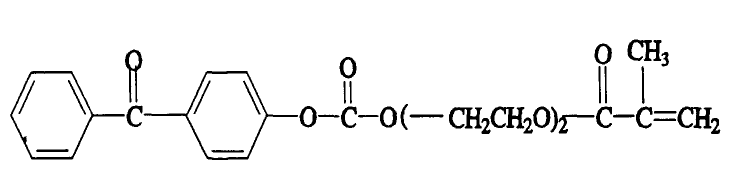
gegeben. Das Gemisch wurde bei 85°C 15 Minuten polymerisiert. Zu der Reaktionsmischung wurden innerhalb von 2 Stunden der Rest der Monomerenmischung und gleichzeitig, aber über 3 Stunden verteilt, eine Lösung von 5 g tert.-Butylperoxy-2-ethyl-hexanoat in 40 g Ethylacetat gegeben. Nach beendeter Zugabe wurde noch 5 Stunden nachpolymerisiert.

Es wurde ein Copolymeres vom K-Wert 38,5 und dem Staudinger-Index (Viskositätszahl) 0,39 erhalten. Das von Lösemittel und flüchtigen Anteilen befreite Copolymere P1 hat bei 120°C eine Schmelzviskosität von 15 Pa·s (D = 100 s⁻¹).

### BEISPIEL 2

### Copolymerisatlösung P2

Zu einem Gemisch von
- 160 g: Ethylacetat,
- 50 g: Tetrahydrofuran und
- 10 g: tert.-Butylperoxy-2-ethyl-hexanoat
wurden 150 g einer Monomerenmischung aus
- 500 g: n-Butylacrylat,
- 330 g: 2-Ethyl-hexylacrylat,
- 150 g: Methylmethacrylat,
- 20 g: Acrylsäure und
- 6,5 g: eines Benzophenonderivats der Formel 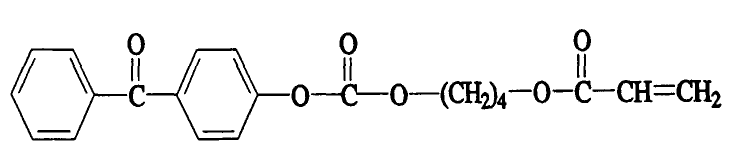
gegeben. Das Gemisch wurde bei 80°C 15 Minuten polymerisiert. Zu der Reaktionsmischung wurden innerhalb von 2 Stunden der Rest der Monomerenmischung und zugleich, aber über 3 Stunden verteilt, eine Lösung von 5 g tert.-Butylperoxy-2-ethyl-hexanoat in 40 g Ethylacetat gegeben. Nach beendeter Zugabe wurde noch 5 Stunden nachpolymerisiert.

Es wurde ein Copolymeres mit einem K-Wert von 48 und einem Staudinger-Index von 0,41 erhalten. Das von Lösemittel und flüchtigen Anteilen befreite Copolymere P2 hat bei 120°C eine Schmelzviskosität von 40 Pa·s (D = 200 s⁻¹).

### BEISPIEL 3

### Copolymerisatlösung P3

Zu einer Mischung aus 280 g eines n-hexanarmen Benzins vom Siedebereich 60 bis 95°C und 70 mg 2,2'-Azobis-isobutyronitril wurden 270 g einer Monomerenmischung aus
- 870 g: 2-Ethyl-hexylacrylat,
- 100 g: Methylmethacrylat,
- 30 g: Acrylsäure und
- 2,0 g: des Benzophenonderivats der Formel 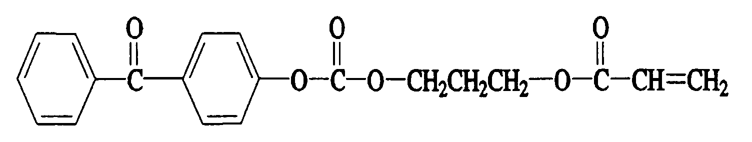
gegeben. Die Reaktionsmischung wurde 15 Minuten bei Rückflußtemperatur anpolymerisiert. Anschließend wurde im Verlauf von zwei Stunden der Rest der Monomerenmischung zugegeben und das Reaktionsgemisch nach beendeter Zugabe noch zwei Stunden unter leichtem Rückfluß gehalten. Anschließend wurden zu der Mischung 10 Gew.-% einer Lösung von 10 g tert.-Butylperoxypivalat in 50 g des oben angegebenen n-hexanarmen Benzins innerhalb von 5 Minuten zugesetzt. Nach einer weiteren Stunde wurden der Rest dieser Lösung und zugleich 670 g des gleichen Benzins zugesetzt.

Es wurde die Lösung eines Copolymeren P3 mit einem K-Wert von 68 erhalten.

### BEISPIEL 4

### Copolymerisat P4

Es wurde verfahren wie für Copolymerisat P2 angegeben, jedoch zur Polymerisation eine Lösung aus
- 800 g: Isoamylacrylat
- 180 g: Vinylacetat,
- 20 g: Methacrylsäure und
- 7,0 g: des Benzophenonderivats der Formel 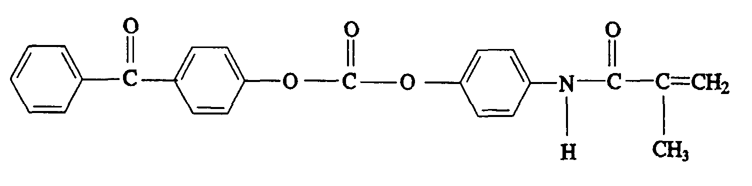
eingesetzt. Es wurde ein Copolymeres mit einem K-Wert von 36 erhalten.

### BEISPIEL 5

### Copolymerisat P5

Es wurde verfahren wie bei Copolymerisat P2 angegeben, jedoch zur Polymerisation eine Lösung aus
- 900 g: Isoamylacrylat,
- 100 g: Macromer® 13 K-RC (Styrololigomeres mit einer Methacrylsäureesterendgruppe; Hersteller Sartomer Inc.) und
- 6,5 g: des Benzophenonderivats der Formel 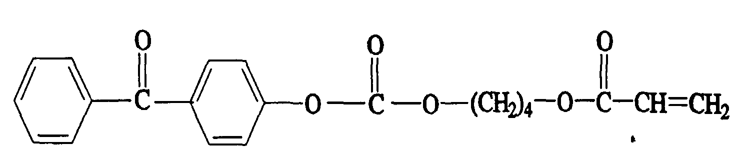
eingesetzt. Es wurde ein Copolymeres mit einem K-Wert von 45 erhalten.

### Beispiele für geeignete Muster

Die folgende Tabelle gibt die typischen Eigenschaften einiger Muster mit kreisrunden Einzelflächen an, die durch eine Maskenbestrahlung oder eine der anderen genannten Methoden auf dem Klebestreifen erzeugt werden können. Zur Herstellung der Muster wurde die Polymerisatlösung P2 eingesetzt. Ähnliche Ergebnisse konnten auch mit den anderen Polymerisatlösungen erhalten werden.

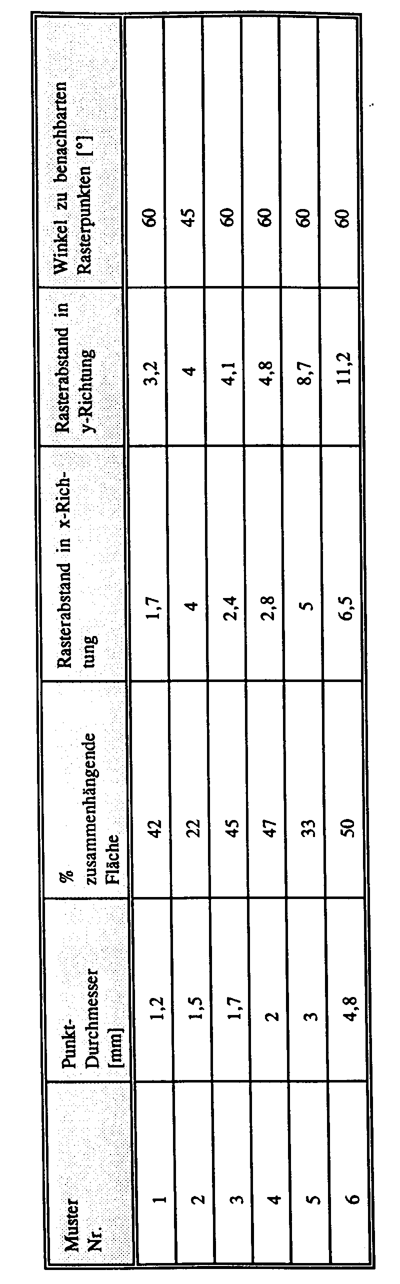

### Ergebnisse der Prüfung der Haftklebstoffeigenschaften

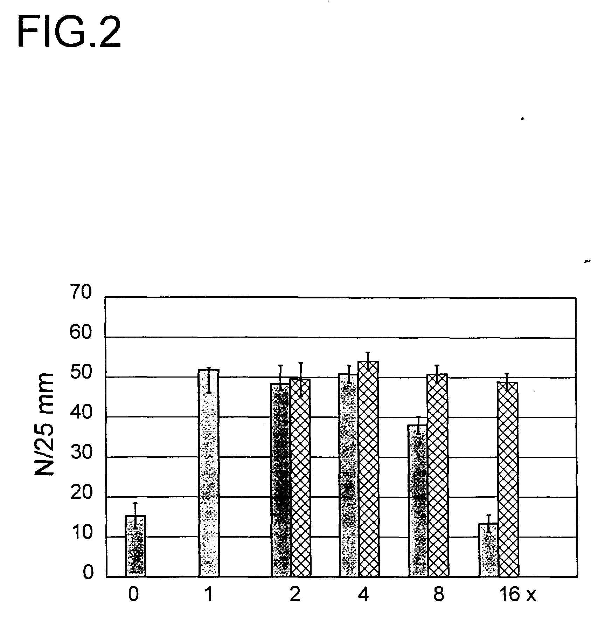

Die Prüfung der Schälfestigkeit ist in Fig. 2 dargestellt.

Auf der Abszisse (x-Achse) ist die Anzahl der Durchläufe unter der Bestrahlungseinheit bei einer Lampenleistung von 160 W/cm, einem Abstand von 10 cm und einer Durchlaufgeschwindigkeit von 10 cm/s angegeben. Die Ordinate (y-Achse) gibt die Schälkraft in N/25 mm Probenbreite an.

Die nicht schraffierten Säulen (bei den mehrfachen Durchläufen jeweils links im Bild) geben die Schälkräfte nach Bestrahlen ohne Maske an; die mit regelmäßigem Raster dargestellten Säulen (jeweils rechts im Bild) geben die Schälkräfte nach Bestrahlen unter einer Lochmaske mit Muster 5 im Abstand von 3 mm von der Klebstoffoberfläche an.

Die homogen bestrahlten Klebestreifen zeigen im unvernetzten Zustand niedrige Schälwerte mit kohäsivem Versagen. Die Schälwerte durchlaufen nach 2 bis 4 Durchläufen ein Maximum bei Mischversagen (teils kohäsiv, teils adhäsiv) und nach 8 Bestrahlungen sind die Klebeigenschaften so weit reduziert, daß es zu einem starken Abfall der Schälwerte unter rein adhäsivem Versagen kommt. Bei Verwendung der Löchmaske wurden die Klebestreifen zuvor einmal ohne Maske durch die Anlage gelassen, um eine homogene Basisvernetzung zu erzeugen.

Der Abfall der Schälwerte bei mehrmaligem Passieren der UV-Anlage ist, wie Fig. 2 zeigt, deutlich reduziert.

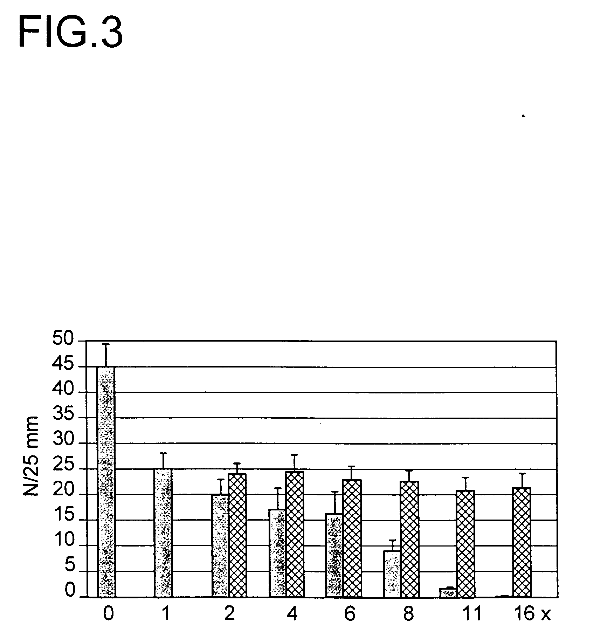

Die Soforthaftung (Tack) wird in Fig. 3 dargestellt.

Die grauen gerasterten Felder zeigen die Soforthaftung nach Bestrahlung ohne Maske; die dunklen Felder die nach Bestrahlung durch Maske Nr.5. Daraus geht hervor, daß nach zweimaligem homogenen Bestrahlen (ohne Maske) mit den gleichen Einstellungen wie bei der Schälfestigkeitsprüfung die Soforthaftung deutlich reduziert wird und nach 8 Durchläufen nahezu verschwindet.

Bei der rastermäßigen Bestrahlung bleibt die Soforthaftung auch nach 8 Durchläufen erhalten. Eine homogene Vorabbestrahlung wurde wie oben beschrieben durch einen Durchlauf unter der UV-Quelle vorgenommen.

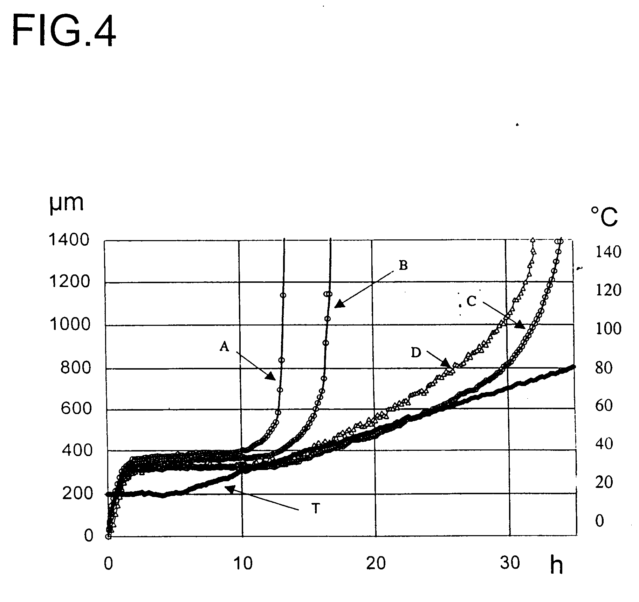

Die Scherfestigkeit wird in Fig. 4 dargestellt.

Auf der Abszisse ist die Zeit in Stunden, auf der Ordinate ist links der Scherweg in µm für die Kurven A bis D und rechts die Temperatur in °C für die Kurve T angegeben. Die Kurve A zeigt das Verhalten nach zweimaliger UV-Bestrahlung ohne Maske, die Kurve B nach viermaliger und die Kurve C nach achtmaliger Bestrahlung ohne Maske. Die Kurve D zeigt das Verhalten nach einmaliger homogener UV-Bestrahlung und siebenmaliger UV-Bestrahlung unter Maske Nr.5. Die Kurve T gibt die Temperatur in °C an, die beim Aufheizen der Proben zum jeweils aus der Abszisse ersichtlichen Zeitpunkt erreicht war.

Die Messungen zeigen, daß die zweimal homogen bestrahlten Klebstreifen (Kurve A) nur eine geringe Scherfestigkeit aufweisen und bereits nach ca. 12 Stunden bei 37 °C versagen. Viermaliges (Kurve B) bzw. achtmaliges (Kurve C) Bestrahlen erhöht die Lebensdauer auf 16 bzw. 34 Stunden und steigert die Versagenstemperatur auf 44 bzw. 78°C.

Der Vergleich eines homogen vernetzten Klebestreifens (Kurve C) mit einer Probe, welche durch einmalige homogene UV-Bestrahlung und anschließende örtlich selektive Maskenbestrahlung (Kurve D) bei einem Maskenabstand von 3 mm durch 7 Durchläufe erzeugt wurde, zeigt nur einen geringen Unterschied bezüglich der Scherfestigkeit. Die Eigenschaften Soforthaftung und Schälfestigkeit gehen jedoch dabei, wie oben dargestellt, im Gegensatz zu dem achtmal homogen bestrahlten Klebestreifen nicht verloren. Dies ist der entscheidende Vorteil des Verfahrens.

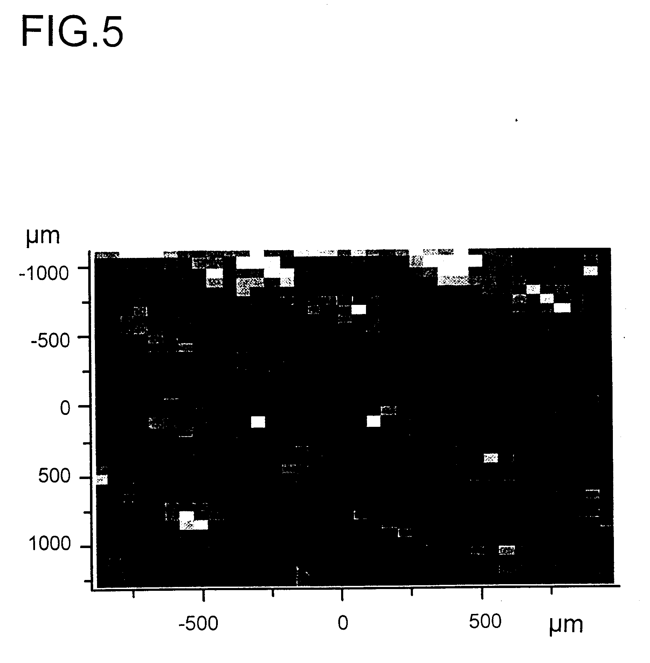

Fig. 5 zeigt die computertomographische Darstellung eines Oberflächenbereichs einer durch UV-Bestrahlung unter einer Löchmaske mit kreisförmigen Löchern von 0,35 mm Durchmesser vernetzten Haftkleberschicht. Dazu wurde die Oberfläche rastermäßig mit Laserlicht abgetastet und für jeden Punkt die Intensität des entstandenen Raman-Streulichts gemessen. Die durch konfokale Ramanspektroskopie erhaltenen Absorptionswerte sind als Maß für den Grad der Vernetzung in der Abbildung durch unterschiedliche Graustufen wiedergegeben. Dabei ist das erhaltene Vernetzungsmuster zu erkennen.

## Patentansprüche

1. Verfahren zur Vernetzung von strahlungsvernetzbaren Haftklebstoffschichten durch dosierte Bestrahlung mit aktinischer Strahlung, dadurch gekennzeichnet, daß man die Schichtoberfläche einem regelmäßigen oder regellosen Strahlungsmuster aus Bereichen unterschiedlicher Intensität aussetzt.

2. Verfahren nach Anspruch 1, dadurch gekennzeichnet, daß das Muster aus Bereichen endlicher Intensität neben strahlungslosen Bereichen besteht.

3. Verfahren nach Anspruch 1, dadurch gekennzeichnet, daß man als aktinische Strahlung UV-Licht oder Elektronenstrahlung einsetzt.

4. Verfahren nach Anspruch 1 , dadurch gekennzeichnet, daß man das Strahlungsmuster durch Fokussieren der Strahlung mittels Linsen erzeugt.

5. Verfahren nach Anspruch 1, dadurch gekennzeichnet, daß man das Strahlungsmuster durch Bestrahlen oder Belichten unter einer Maske erzeugt.

6. Verfahren nach Anspruch 1, dadurch gekennzeichnet, daß man das Strahlungsmuster durch rastermäßige Bestrahlung der Oberfläche mittels einer zeitlich und örtlich gesteuerten Quelle für punktförmige Bestrahlung erzeugt.

7. Verfahren nach Anspruch 1, dadurch gekennzeichnet, daß die Bereiche unterschiedlicher Intensität eine Ausdehnung von 0,001 bis 10 mm haben.

8. Verfahren nach Anspruch 1 oder 7, dadurch gekennzeichnet, daß der flächenmäßige Anteil der Bereiche höherer Intensität zwischen 2 und 98 % der zu bestrahlenden Oberfläche liegt.

9. Verfahren nach Anspruch 1, dadurch gekennzeichnet, daß man die mustermäßige Bestrahlung mit einer homogenen Bestrahlung kombiniert.
